(19)

Europäisches
Patentamt
European
Patent Office
Office européen
des brevets

(11)  **EP 2 203 756 B1**

(12)  **EUROPEAN PATENT SPECIFICATION**

(45) Date of publication and mention
of the grant of the patent:
**13.04.2011  Bulletin 2011/15**

(51) Int Cl.:
***G01R 33/06*** *(2006.01)*   ***H01L 43/06*** *(2006.01)*

(21) Application number: **08807981.9**

(22) Date of filing: **16.10.2008**

(86) International application number:
**PCT/IB2008/054261**

(87) International publication number:
**WO 2009/050673 (23.04.2009 Gazette 2009/17)**

(54) **MAGNETIC FIELD SENSOR**

MAGNETFELDSENSOR

DÉTECTEUR DE CHAMP MAGNÉTIQUE

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **18.10.2007  EP 07118816**

(43) Date of publication of application:
**07.07.2010  Bulletin 2010/27**

(73) Proprietor: **NXP B.V.**
**5656 AG Eindhoven (NL)**

(72) Inventors:
• **ZIEREN, Victor**
**Redhill Surrey RH1 1DL (GB)**

• **WOLTERS, Robertus, A., M.**
**NL-5656 AG Eindhoven (NL)**

(74) Representative: **Krott, Michel**
**NXP B.V.**
**Intellectual Property & Licensing Department**
**High Tech Campus 32**
**5656 AE  Eindhoven (NL)**

(56) References cited:
**US-A- 4 700 211        US-A1- 2004 212 029
US-A1- 2005 230 770**

EP 2 203 756 B1

## Description

FIELD OF THE INVENTION

The invention relates to a magnetic field sensor, an integrated circuit comprising such magnetic field sensor, and a card comprising such an integrated circuit. BACKGROUND OF THE INVENTION A lot of solutions for magnetic-field detection in silicon ICs exist, such as the well-known Hall plates with integrated amplifier, magnetotransistors of bipolar or unipolar nature (JFETs or MOSFETs), magnetoresistors and magnetodiodes.

US 4700211 discloses a magnetic field sensor having a lateral bipolar magneto transistor incorporating only a single emitter region and whose base region is incorporated as a well in the surface of a silicon substrate of the reverse material conduction type. The P/N junction of the base region with the silicon substrate is reverse biased by means of at least one secondary collector contact. The emitter region must be kept as shallow than 0.5 mu m or be so lowly doped with impurity atoms that its resistivity is greater than 100 ohms per square or both. The sensitivity of the magnetic field sensor is approximately 100%/Tesla.

US 2004/212029 discloses a magnetic field sensor includes a transistor device having a base region, an emitter region, and a collector region. A barrier region disposed between the emitter region and the collector region to hamper charge carriers injected into the base region from the emitter region from reaching at least a portion of the collector region. The magnetic field sensor further includes a first voltage source to bias the collector region with respect to the base region to form a space-charge layer associated with the collector region.

US 2005/230770 describes a vertical Hall device includes: a substrate; a semiconductor region having a first conductive type and disposed in the substrate; and a magnetic field detection portion disposed in the semiconductor region. The magnetic field detection portion is capable of detecting a magnetic field parallel to a surface of the substrate in a case where a current flows through the magnetic field detection portion in a vertical direction of the substrate. The semiconductor region is a diffusion layer including a conductive impurity doped and diffused therein. The semiconductor region is made of diffusion layer so that the device has high design degree of freedom.

US2005/0230770 discloses a vertical Hall device including: a substrate; a semiconductor region having a first conductive type and disposed in the substrate; and a magnetic field detection portion disposed in the semiconductor region. The magnetic field detection portion is capable of detecting a magnetic field parallel to a surface of the substrate in a case where a current flows through the magnetic field detection portion in a vertical direction of the substrate. The semiconductor region is a diffusion layer including a conductive impurity doped and diffused therein. The semiconductor region is made of diffusion layer so that the device has high design degree of freedom. The vertical Hall device is arranged for measuring magnetic field component parallel to the chip surface. A drawback of this Hall device is its relatively low sensitivity and linearity.

GB2126009 A discloses a magnetic field sensor comprising a lateral bipolar magnetotransistor having only one single emitter region and a base region. The base region is heavily doped with impurity atoms, and is incorporated in the surface of a silicon substrate that is lightly doped with impurity atoms. The silicon substrate is of opposite conductivity to the base region to provide a PN junction between the base region and the substrate. The PN junction is reverse biased by means of at least one secondary collector contact provided in the surface of the silicon substrate. The emitter region, collector regions and the base contact of the magnetotransistor are adjacently aligned. A major drawback of the lateral bipolar magnetotransistor is that it is not compatible with triple-well technology, which is caused by the very special emitter requirements. For instance, a low emitter doping is required and the emitter and base regions are in most embodiments arranged as parallel stripes covered by a single emitter electrode, which increases the base current for increasing the emitter efficiency.

In Schneider et al, "Integrated micromachined decoup/ed CMOS chip on chip", Micro Electro Mechanical Systems, 1997, MEMS '97, Proc. IEEE, 26-30 Jan 1997, pp 512-517 a novel technology for the fabrication of thermally, electrically, and mechanically decoupled n-doped silicon microstructures is disclosed. The n-silicon may contain p-well regions and, therefore, unrestricted CMOS circuitry and transducers. Furthermore, the technology enables the inexpensive fabrication of silicon membranes with different thicknesses without using epilayer wafers. It is based on a commercially available industrial CMOS multi-well process which is followed by an anisotropic KOH etching step from the wafer backside using an electrochemical etch stop. As an example, a decoupled CMOS magnetic sensor microsystem in a deep-N-well was realized. The well is suspended by a dielectric membrane. The thermal isolation of the suspension has a thermal resistance of 4600°C/W. The microsystem has a thermal time constant of 3.3 ms. The stabilization of the sensor operation temperature reduces drift effects of the sensor signal offsets related to ambient temperature changes by a factor of 5. A drawback of this technology is that it is not compatible with triple-well technology. Various additional steps like the etching step from the backside are required.

As will be appreciated from the above, the known magnetic field sensors suffer, depending on the solution chosen, from various disadvantages like low sensitivity, low linearity, incompatibility with conventional baseline CMOS technology (because of additional process steps required), which is generally a triple-well technology.

## SUMMARY OF THE INVENTION

It is an object of the invention to provide a magnetic field sensor having a high sensitivity and linearity, and that is compatible with triple-well CMOS technology. Sensors which are compatible with triple-well CMOS technology are of particular interest, because starting from the 65nm technology node and further all baseline CMOS processes are expected to be of the triple-well type, see the following links, for instance: "http://www.commsdesign.com/ showArticle.jhtml? articleID=192200561", and "http://www.fujitsu.com/downloads/MICRO/fma/pdf/MixSigna10407.pdf '.

No additional processing steps for the sensors are then needed when integrating such magnetic field sensor in a conventional CMOS technology.

The invention is defined by the independent claims. The dependent claims define advantageous embodiments.

In a first aspect, the invention relates to a magnetic field sensor comprising a silicon comprising semiconductor substrate having a first side, the substrate being of a first conductivity type, the substrate comprising a buried N-well, the substrate comprising a bipolar transistor having an emitter, a base, and a collector, the substrate comprising: a first collector region and a second collector region of the second conductivity type, the first and second collector regions forming part of the collector of the bipolar transistor, wherein the emitter is located at the first side above the buried N-well, wherein the first and second collector regions, the base, and the emitter are positioned with respect to each other such that, in operation, a part of an emitter current that traverses the base is distributed over the first and second collector regions obtaining a first and a second collector current, wherein a difference between the first and second collector currents is determined by a magnetic field component perpendicular to a current plane, wherein the current plane is defined through the emitter, the base and the first and second collector regions and extends in directions defined by the emitter current and the first and second collector currents.

The effect of the features of the magnetic field sensor according to the invention is that a bipolar magneto-transistor structure is obtained which is compatible with triple-well technology and that is sensitive to magnetic fields in a direction perpendicular to the current plane. The compatibility of the magnetic field sensor with triple-well technology also resides in the presence of a buried N-well underneath the emitter region. The split-collector configuration enables a high linearity and a high sensitivity.

Preferably, an emitter region of a second conductivity type forms the emitter of the bipolar transistor, and a base region of the first conductivity type forms the base of the bipolar transistor.

In an embodiment of the magnetic field sensor according to the invention the current plane extends in a direction perpendicular to the first side of the substrate, wherein the collector regions are formed in the buried N-well, wherein the base region is a p-type semiconductor and the emitter region is n-type semiconductor. This embodiment constitutes a vertical bipolar npn magneto-transistor structure which has the advantage that it is sensitive to fields parallel to the first side of the substrate. This embodiment relies on the insight that the buried N-well in a triple-well CMOS technology, which normally is used for isolation of P-wells in a semiconductor device, can be used as a current path for the collector current of a bipolar transistor.

In an embodiment of the magnetic field sensor according to the invention the buried N-well comprises two parts separated in a direction parallel to the first side by a separating region of the substrate, the two parts forming the first and second collector regions. This embodiment is advantageous because it features control of the distribution of the emitter current that traverses the base region, over the first and second collector regions. With control of the distribution is meant the current distribution which is achieved in case there is no magnetic field present, which may be referred to as the zero-field current distribution. Process variations may cause an offset in the zero-field current distribution, which may be compensated for by intentionally displacing the separating region with respect to the emitter current. Alternatively, an intentional offset may be given to the zero-field current distribution which may be used to provide for a more variable or "random" read-out of the magnetic field sensor when considering a plurality of them.

In an embodiment of the magnetic field sensor according to the invention the separating region of the semiconductor substrate is centrally aligned with the emitter region when viewed from a direction perpendicular to the substrate. This embodiment may feature an equal zero-field distribution of the emitter current that traverses the base region, over the first and second collector regions.

In an embodiment of the magnetic field sensor according to the invention the separating region of the semiconductor substrate and the emitter region are centrally offset with a predefined distance when viewed from a direction perpendicular to the substrate. The amount of offset determines the distribution of the emitter current that traverses the base region over the collector regions. The more the separating region is located at the side of the first collector region, the more the emitter current that traverses the base region flows to the second collector region, and vice versa. This may be used to achieve the effect discussed earlier.

In an embodiment of the magnetic field sensor according to the invention the sensor further comprises n-type contact regions extending from the first side to the collector regions in the buried N-well for featuring electrical connects from the collector regions to a circuit. The n-type contact regions may be placed at any suitable position as long as its position with respect to the emitter region and the base region is such that it does not influence the current distribution. This basically means that it should not be too close to the emitter region. Also, preferably, the contact regions should be placed at equal distance from the emitter region so as to assure a more equal current distribution.

In an embodiment of the magnetic field sensor according to the invention the sensor further comprises a third collector region and a fourth collector region of the second conductivity type, the third and fourth collector region forming part of the collector of the bipolar transistor, wherein the third and fourth collector region, the base region, and the emitter region are positioned with respect to each other such that, in operation, a part of an emitter current that traverses the base region is also distributed over the third and fourth collector regions obtaining a third and a fourth collector current, wherein a difference between the third and fourth collector currents is determined by a further magnetic field component perpendicular to a further current plane that extends in a direction perpendicular to the first side of the substrate, wherein the further current plane is defined through the emitter region, the base region and third and fourth collector regions and extends in directions defined by flow directions of the emitter current and the third and fourth collector currents. This embodiment effectively constitutes a 2-in-1 magnetic field sensor which advantageously features a 2-dimensional magnetic field direction measurement. A first magnetic field component is measured by the first and second collector regions, perpendicular to the current plane, and a second magnetic field component is measured by the third and fourth collector regions, in a direction perpendicular to the further current plane.

In an embodiment of the magnetic field sensor according to the invention the current plane and the further plane are perpendicular with respect to each other. In such a configuration the actual magnetic field direction can be determined from the two field-vector components measured by the collector regions.

In an embodiment of the magnetic field sensor according to the invention the collector regions, the base region, and the emitter region are located at the first side above the buried N-well and positioned with respect to each other in a direction parallel to the first side. This embodiment constitutes a lateral bipolar magneto-transistor structure which has the advantage that it is sensitive to fields perpendicular to the first side of the substrate. This embodiment is very advantageous when used in combination with a vertical bipolar magneto-transistor structure or a 2-in-1 2-dimensional magnetic field sensor, which features a 2D magnetic field measurement (in a plane perpendicular to the first side of the substrate) and a 3D magnetic field measurement respectively.

In an embodiment of the magnetic field sensor according to the invention the collector regions and the emitter region of the second conductivity type are formed in the base region of the first conductivity type. This embodiment features the application of additional drift fields or Hall fields in the base region.

In a first variant of last mentioned embodiment the base region comprises two base contact regions of the first conductivity type but having a higher dopant concentration, a first one of the two base contact regions being positioned on a side of the emitter region opposite to a side facing the collector regions, and a second one of the two base contact regions being positioned on a side of the collector regions opposite to a side facing the emitter region. The structure thus obtained constitutes a lateral drift-aided bipolar magnetotransistor in triple-well CMOS technology, which is sensitive to vertical magnetic field components.

In a second variant the base region comprises two base contact regions of the first conductivity type but having a higher dopant concentration, a first one of the two base contact regions being positioned on a side of the emitter region facing the collector regions, and a second one of the two base contact regions being positioned on an opposing side of the emitter region. The structure thus obtained constitutes a lateral bipolar magnetotransistor with injection modulation in triple-well CMOS technology, which is sensitive to vertical magnetic field components.

In a second aspect the invention relates to an integrated circuit comprising at least one magnetic field sensor in accordance with the invention:

- the substrate having the first side and a second opposing side;
- an electronic circuit provided at the first side of the substrate, wherein the electronic circuit comprises the at least one magnetic field sensor, and
- a magnetizable region provided on the second side of the substrate by using a wafer-level type deposition processing step, a magnetic moment of the magnetizable region being configurable for generating a magnetic field detectable at the location of the at least one magnetic field sensor.

Such integrated circuit constitutes a very simple construction providing a first level of security against external attack. All what is needed is a magnetizable region on the second side and at least the magnetic field sensor according to the invention, on the first side of the substrate. These additional features can be provided on the substrate using conventional deposition techniques which enables a strongly miniaturized solution which is, because of its reduced dimensions well suitable for being used in bank cards. An attempt to remove the integrated circuit according to the invention from its environment (e.g. a bank card) may result in the magnetizable region getting damaged (partially removed) or even completely removed. In case the magnetizable region has been magnetized (such that it has a magnetic moment that results in a magnetic field detectable at the location of the at least one magnetic field sensor) this damaging or removal may be detected by the at least one magnetic field sensor which provides a first level of security against external attack.

Preferably, the electronic circuit at least comprises CMOS circuitry. CMOS circuitry is fully compatible with triple-well technology and this embodiment thus features easy integration of the magnetotransistor (which is compatible with triple-well technology) with the electronic circuit.

In a third aspect the invention relates to a card comprising an integrated circuit in accordance with the invention. Such a card will not work after (partial) removal/ damaging of the magnetizable region of the integrated circuit. Such (partial) removal/damaging may already happen when the integrated circuit is removed from the card. Alternatively, in some embodiments a hacker might want to change the magnetization of the magnetizable region (in case of reprogramming). The invention enables the detection of this type of hacking also. Before any operation of the card the authenticity of the integrated circuit may be checked. As the actual value of the of the magnetic field of the at least one magnetic field sensor can be compared with the first reference value that is stored, it is in effect impossible to remove or damage the magnetizable region without the magnetic field sensor detecting such event. Therefore, the card that includes the integrated circuit of the invention can be detected to be not authentic anymore after (partial) removal of the magnetizable region.

The card of the invention is preferably a smart-card containing any financial or private data or giving access to any building or information. For such smart-cards the safety requirements show a steady increase, which is related to the increasing confidence and use of these smartcards. Alternatively, the card may be a transponder-type of card that can be read out contactlessly. The card can be a banknote as well. In this case the integrated circuit must be very thin. Another type of a card is a SIM-card for a mobile phone. In case of contactless readout the card will contain an antenna to communicate with the access device. The electronic circuit in the integrated circuit is then connected to said antenna.

These and other aspects of the invention are apparent from and will be elucidated with reference to the embodiments described hereinafter.

BRIEF DESCRIPTION OF THE DRAWINGS

In the drawings:

Fig. 1 shows a schematic cross-sectional view of a magnetic field sensor in accordance with a first embodiment of the invention;
Fig. 2 shows a schematic cross-sectional view of a magnetic field sensor in accordance with a second embodiment of the invention;
Fig. 3 shows a schematic top-view and a more-detailed schematic cross-sectional view of the magnetic field sensor of Fig. 1;

Fig. 4 shows a schematic top-view and a more-detailed schematic cross-sectional view of the magnetic field sensor of Fig. 2;
Fig. 5 shows a schematic top-view of a magnetic field sensor in accordance with a third embodiment of the invention;
Fig. 6 shows a schematic top-view of a magnetic field sensor in accordance with a fourth embodiment of the invention;
Fig. 7 shows a schematic top-view of a magnetic field sensor in accordance with a fifth embodiment of the invention;
Fig. 8 shows a schematic top-view and cross-sectional view of an integrated circuit in accordance with a sixth embodiment of the invention;
Fig. 9 shows a schematic top-view and cross-sectional view of an integrated circuit in accordance with a seventh embodiment of the invention, and
Fig. 10 shows a schematic cross-sectional view of a card in accordance with an 8th embodiment of the invention.

DETAILED DESCRIPTION OF THE PREFERRED EMBODIMENT

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage. Throughout the Figures, similar or corresponding features are indicated by same reference numerals or labels.

A lot of solutions for magnetic-field detection in silicon ICs exist, such as the well-known Hall plates with integrated amplifier, magnetotransistors of bipolar or unipolar nature (JFETs or MOSFETs), magnetoresistors and magnetodiodes. Sensors which are compatible with triple-well CMOS technology are of particular interest, because starting from the 65nm technology node and further all baseline CMOS processes are likely to be of the triple-well type see the following links, for instance:

"http://www.commsdesign.com/showArticle.jhtml? articleID=92200561", and

"http://www.fujitsu.com/downloads/MICRO/fma/pdf/MixSigna10407.pdf".

No additional processing steps for the sensors should be needed, because of technology exploitation reasons.

In this description the "front-side" of an integrated circuit is defmed as the side of the integrated on which circuitry is provided. This side is also being referred to as the "first side of the substrate" in this description. Likewise, the "back-side" of the integrated circuit is defined as the side opposite to the front-side and this side is also being referred to as the "second side of the substrate" in this description.

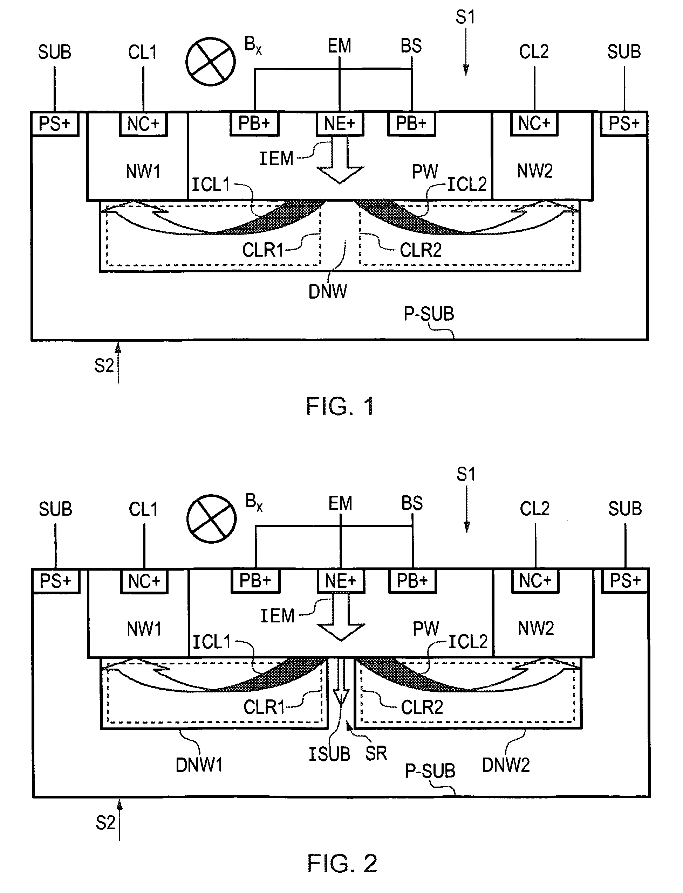

Fig. 1 shows a schematic cross-sectional view of a magnetic field sensor in accordance with a first embodiment of the invention. The magnetic field sensor comprises a p-type silicon comprising substrate P-SUB having a first side S1 (front-side) and a second side S2 (backside). Alternatively, any type of substrate (eg. in silicon-on-anything technology) may be used having a p-type silicon comprising layer provided on top of it. A bipolar (npn) vertical magnetotransistor (VMT) is implemented in the following way. A P-well PW is formed at the first side S1 of the substrate P-SUB of which part forms the base region and acts as a base of the bipolar transistor. The substrate is contacted via substrate contact regions PS+ which are connected to a substrate terminal SUB of the bipolar transistor. In the P-well PW heavily doped p-type contact regions PB+ are formed which are connected to a base terminal BS. In the P-well PW a heavily doped n-type region NE+ is formed which acts as an emitter. The emitter is connected to an emitter terminal EM. Under the P-well PW a buried N-well DNW is formed which is arranged to act as the collector of the bipolar transistor. The buried N-well DNW is contacted on two opposite sides of the emitter region NE+ by N-well regions NW1, NW2 forming contact regions. The contact regions NW1, NW2 are connected to collector terminals CL1, CL2 via highly-doped n-type regions NC+. This geometry ensures that, during operation of the bipolar transistor, an emitter current IEM that traverses the base region is divided in two collector currents ICL1, ICS2. Effectively, this means that the buried N-well DNW comprises two collector regions CLR1, CLR2 over which the emitter current IEM that traverses the base region is distributed. The geometry may be designed such (in terms of symmetry, dimensions, doping profiles, etc) that in case of a zero magnetic field the collector currents CL1, CL2 are equally large. During operation of the bipolar transistor, an in-plane magnetic field component $B_x$ perpendicular to a current plane (flux density) will cause a differential collector current (or a difference in collector currents ICL1, ICL2) that is proportional to the in-plane flux-density component $B_x$. The current plane is defined as the plane through the emitter region NE+, the base region PW and the collector regions CLR1, CLR2 which extends in directions defined by the flow directions of the emitter current IEM (perpendicular to the first side S1 of the substrate P-SUB) and the collector currents ICL1, ICL2. In the above example, the current plane coincides with the plane of the drawing in Fig. 1.

The magnetic field sensor in Fig. 1 is compatible with triple-well CMOS technology, which is most likely used for all technology nodes of 65 nm and beyond (for more information on triple-well see: "http://www.thresholdsystems.com/news_sr.htm" under Point 2a). The compatibility is caused to a large extend by the buried N-well DNW, the P-well PW, and the N-wells NW1, NW2. It must be stressed, however, that in the prior art, the function of the buried N-well is to electrically isolate P-wells which are located in it. This is done by properly biasing the wells to the right voltage such that pn-junctions are reverse-biased. Such biasing techniques are well-known to the person skilled in the art. This particular embodiment, wherein the buried N-well in a triple-well CMOS technology is used as a current distributor or current divider, is not something a person skilled in the art would consider and is considered to be the insight of the inventors.

In order to use the magnetic field sensor of the invention circuitry is needed which measures the current difference in order to obtain a value of the magnetic field component perpendicular to the current-plane. One way of measuring the magnetic field sensor's response is to bias it with a constant emitter current source (not shown), to connect the collectors to a current mirror, and to connect one of the collectors to a current-to-voltage converter. It is considered well-known to the person skilled in the art to build such measurement circuitry or to provide alternative ones. In case of the above-mentioned set-up the output will be:

$$\Delta I_C = K \cdot B_x \cdot I_E \cdot \mu_{Hn},$$

wherein $B_x$ is the value of the magnetic field component in the x-direction, $1_E$ is the emitter current $\mu_{Hn}$ is the n-type Hall mobility and K is a constant dependent on geometry and processing parameters.

In this description, bipolar transistor physics and operation are considered as well-known to the person skilled in the art and is therefore just briefly discussed in this description.

All conductivity types in the above illustrated example may be inverted (p-type to n-type, and n-type to p-type). In that case a technology is obtained having a buried P-well instead of a buried N-well. Although, this is a less conventional technology, it must be stressed that such technology is still feasible. The highly doped contact regions in the above example are not essential, but optional. Still, it is very advisory to use such contact regions, e.g. for reducing the contact resistance or for avoiding the formation of a Schottky diode at the contacts to the bipolar transistor (not shown).

Fig. 2 shows a schematic cross-sectional view of a magnetic field sensor in accordance with a second embodiment of the invention. This embodiment differs from the embodiment in Fig. 1 in that the collector regions CLR1, CLR2 are now formed as two separate buried N-wells DNW1, DNW2 which are separated in a direction parallel to the first side S1 of the substrate by a separating region SR. The separating region SR may be any type of non-conducting material or it may be, as is the case in this embodiment, part of the substrate P-SUB which is of an opposite conductivity type as the buried N-wells DNW1, DNW2. In this embodiment the potential of the emitter terminal EM is preferably kept at a negative potential with respect to the potential of the base terminal BS and the substrate terminal SUB (which is normally grounded). The base terminal BS is preferably connected to the substrate terminal SUB. This measure assures that the pn-junction at the base-emitter interface is forward-biased. The base-substrate interface then has no potential difference to prevent a substantial substrate current ISUB to occur which reduces the efficiency of the sensor. The electrons injected from the emitter are traversing the base region, where they are minority carriers. They will preferably flow to the collector regions at a higher potential than the substrate potential. The base transport factor of the bipolar transistor is, amongst other parameters, dependent on the base length. A rather long base length will result in a bipolar transistor with a very low base transport factor, or a high recombination. This will increase the base current and decrease the collector current. So, in order to decrease the recombination of the minority carriers (electrons) with the majority carrriers (holes) in the base, the base length should preferably be small.

It is very likely that there is offset present in the output signal of the magnetic field sensor of Fig. 2 due to alignment errors or mismatches in the two sections of this intentionally symmetrical structure. With offset, it is meant that there is a difference between the collector currents ICL1, ICL2 when there is no magnetic field component $B_x$ perpendicular to the current plane. Mismatches may be the result of inhomogeneities in the doping levels of the wells NW1, NW2, DNW1, DNW2, PW. In some embodiments, this is not a big problem as long as the value of the offset is known and constant. Then the sign and magnitude of the offset may even help to randomize output of individual sensors in an array of sensors. Such array of sensors may be used in fingerprint or encryption key generation applications.

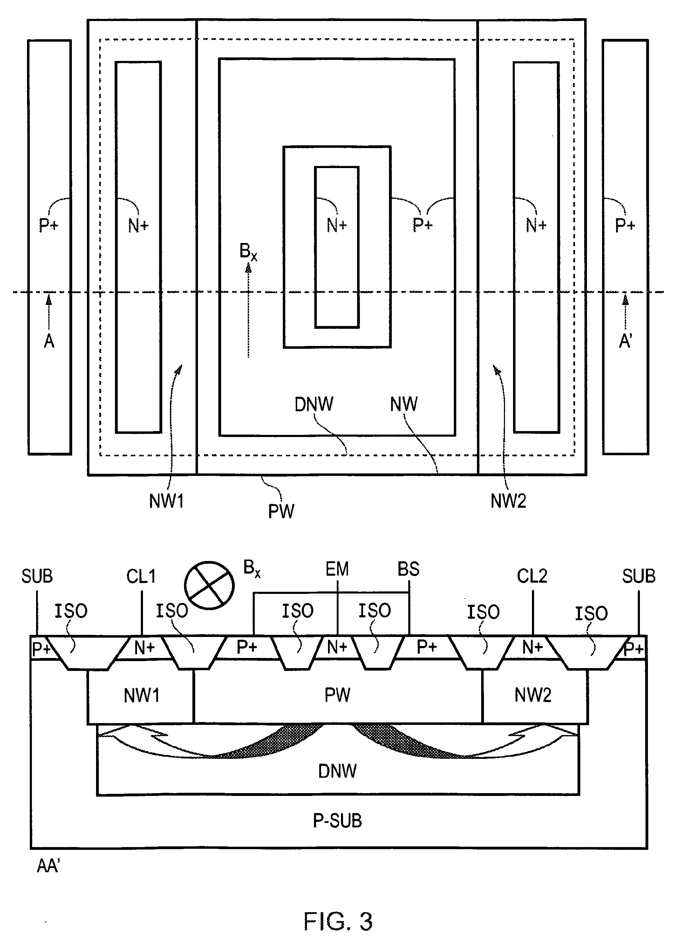

Fig. 3 shows a schematic top-view and a more-detailed schematic cross-sectional view of the magnetic field sensor of Fig. 1. In this figure the isolation regions ISO are shown. The isolation regions ISO define areas where no diffusion regions may be formed. The regions preferably comprise silicon oxide in the form of shallow-trench isolation, also being referred to as STI, or local oxidation of silicon, also being referred to as LOCOS. However, other electrically isolating materials (like silicon nitride) are also possible, see for instance "http: //www.thresholdsystems.com/news_sr.htm".

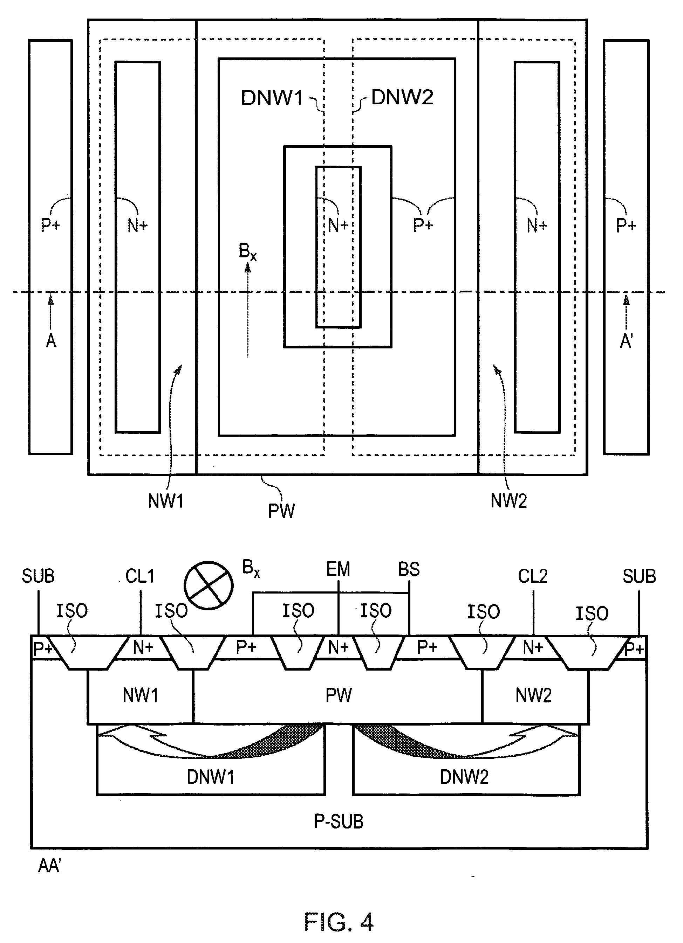

Fig. 4 shows a schematic top-view and a more-detailed schematic cross-sectional view of the magnetic field sensor of Fig. 2. In this figure the isolation regions ISO are shown in a way similar to Fig. 3.

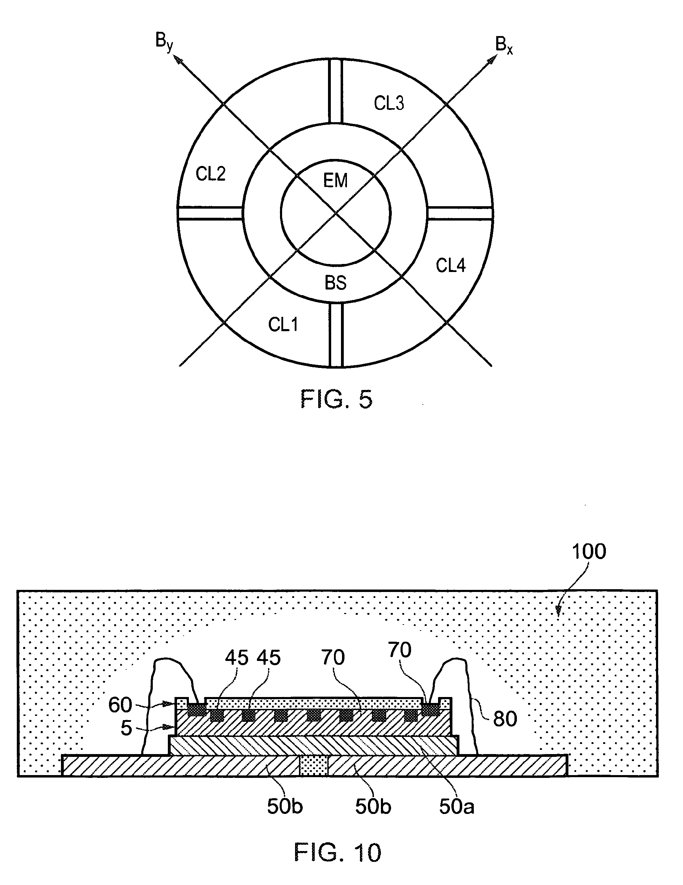

Fig. 5 shows a schematic top-view of a magnetic field sensor in accordance with a third embodiment of the invention. The embodiments illustrated in Figs. 1 and 2 may be extended towards two-dimensional field measuring capabilities by adding another pair of collector regions for enabling the measurement of a further magnetic field component $B_y$ in a direction parallel to the first side of the substrate. Effectively, a bipolar transistor having 4 collector terminals (CL1, CL2, CL3, CL4) is achieved instead of two. Preferably, the structure is designed symmetrically as illustrated in Fig. 5, which means that the current plane and the further current plane are perpendicular with respect to each other.

In the embodiment as illustrated in Fig. 5, during operation of the magnetic field sensor, collector regions C1 and C3 measure a first magnetic field component By, wherein the following formula may be derived:

$$\Delta I_{C13} = K' \cdot B_y \cdot I_E \cdot \mu_{Hn}.$$

wherein $\Delta I_{C13}$ is the difference in collector current between the collector regions C1, C3, wherein By is the value of the magnetic field component in the y-direction, $I_E$ is the emitter current, $\mu_{Hn}$ is the n-type Hall mobility, and K' is a constant dependent on geometry and processing.

For the collector regions C2 and C4, measuring field component $B_x$ a similar formula may be derived:

$$\Delta I_{C24} = K' \cdot B_x \cdot I_E \cdot \mu_{Hn}.$$

wherein $\Delta I_{C24}$ is the difference in collector current between the collector regions C2, C4, wherein $B_x$ is the value of the magnetic field component in the x-direction, $I_E$ is the emitter current, $\mu_{Hn}$ is the n-type Hall mobility, and K' is a constant dependent on geometry and processing.

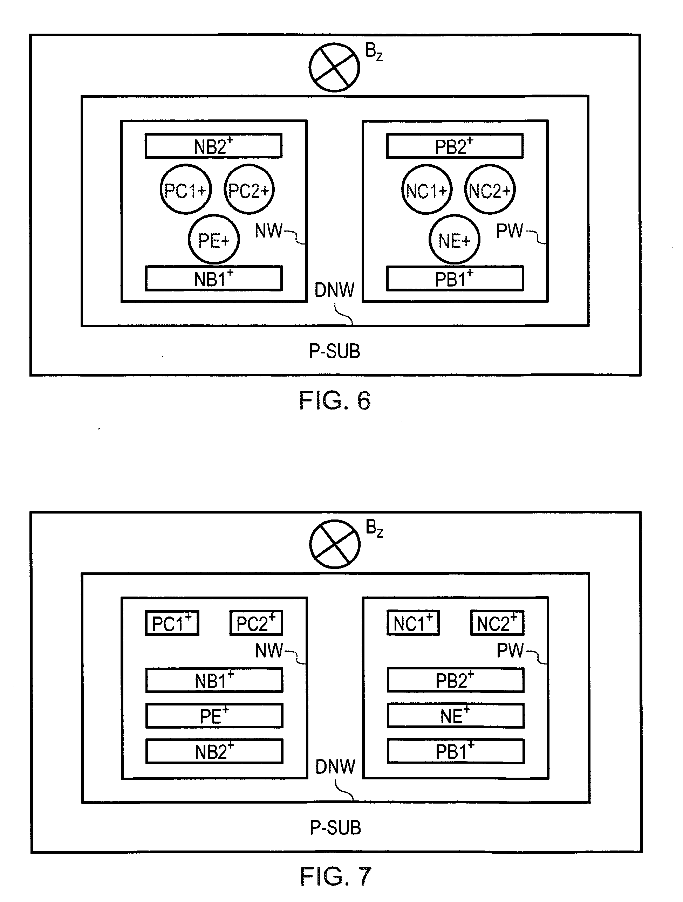

Figs. 6 and 7 show a schematic top-view of a magnetic field sensor in accordance with a fourth embodiment and a fifth embodiment of the invention. The embodiments constitute lateral magnetotransistors (LMT) compatible with triple-well CMOS technology. The LMT is sensitive to a magnetic field component perpendicular to the chip surface ($B_z$). In the embodiments of the magnetic field sensors of Fig. 6 and 7 the collector regions NCl+, NC2+, Pal+, PC2+, the base region (formed by the N-well NW or P-well PW), and the emitter region NE+, PE+ are located above the buried N-well DNW and positioned with respect to each other in a direction parallel to the first side of the substrate P-SUB.

Fig. 6 shows a so called drift-aided LMT of the pnp (left) and the npn (right) type. There are two base contact regions NB1+, NB2+, PB1+, PB2+ arranged on both sides of the N-well (for the pnp-type) and the P-well (for the npn-type) for applying an electric field (by applying a different voltage on the contact regions) in the base region that helps the injected minority charge carriers from the emitter PE+, NE+ to reach the two collectors PC1+, PC2+, NC1+, NC2+. The current flowing between the two base terminals is a majority carrier current (electrons for the pnp-type and holes for the npn-type), as a result of which a lateral Hall field will build up, which influences the flow of minority carriers injected in the base region (holes in the pnp-type and electrons in the npn-type). The Lorentz force acting on these minorities thus has an additional effect, as it increases the differential collector current due to an additional Hall angle. The following formula may be derived:

$$\Delta I_C = K''B_z I_E (\mu_{Hn} + \mu_{Hp})$$

wherein $\Delta I_c$ is the difference in collector current between the collector regions PC1+, PC2+, wherein $B_z$ is the value of the magnetic field component in the z-direction, $I_E$ is the emitter current, $\mu_{Hp}$ is the p-type Hall mobility, $\mu_{Hn}$ is the n-type Hall mobility, and K'' is a constant dependent on geometry and processing. The physics behind and the operation of a drift-aided LMT is well-known to the person skilled in the art, for instance in S. Middelhock and S.A. Audet, "Silicon sensors", Academic Press, 1989, ISBN 0-12- 495051-5.

Fig. 7 shows an injection modulation LMT wherein a Hall voltage over the base-emitter junction causes a differential collector current. Both the pnp (left) and the npn type (right) are shown. There are two base contact regions NB1+, NB2+ arranged on both sides of the emitter region PE+, NE+. By applying a different voltage on the contact regions a Hall-voltage will build up which causes the injection into the base region (formed by the well regions NW, PW) to be non-uniform (e.g. the left-hand side of the emitter will inject more than the right-hand side). The physics behind and the operation of an injection modulation LMT is well-known to the person skilled in the art, for instance in S. Middelhoek and S.A. Audet, "Silicon sensors", Academic Press, 1989, ISBN 0-12- 495051-5.

There is an increasing need to protect IC's against physical attacks which aim at retrieving data there from. Physical attacks from the back side of an 1C are becoming an increasingly important threat for IC's, and especially for bank cards. Although in the prior various schemes for back-side protection of IC's are proposed, these schemes constitute complex and costly solutions. Above that, the known schemes are, due to their complexity, not compatible with conventional lithography and must be carried out in later stages of the manufacturing process.

In this description the "front-side" of a semiconductor device is defined as the side of the semiconductor device on which circuitry is provided. This side is also being referred to as the "first side of the substrate" in this description. Likewise, the "back-side" of the semiconductor device is defined as the side opposite to the front-side and this side is also being referred to as the "second side of the substrate" in this description.

Where in this application it is mentioned that a magnetic field is "detectable" it is meant that it should locally at least exceed the value of any background magnetic field (such as the earth magnetic field) and preferably it should exceed this by a factor of ten. It is difficult to specify what the real lower limit is. First of all, in case the background magnetic field is the earth magnetic field, its strength and direction heavily depend on geographical location, altitude, etc. Secondly, it depends on the sensitivity of the magnetic field sensor used and eventual peripheral circuitry around it that is arranged to compensate for low signal-to-noise ratios. It is considered to fall within the normal means and the capacity for routine work and experimentation of the skilled person to come up with a functioning magnetic field sensor for a specific background magnetic field.

Where in this application the word "substrate" is mentioned, it is meant the substrate and everything that is integrated therein by means of wafer-level type deposition processing steps including steps like: chemical vapor deposition (CVD), low-pressure chemical vapor deposition (LPCVD), physical vapor deposition (sputtering), spin coating, spray coating, atomic layer deposition (ALD), or plasma-enhanced chemical vapor deposition (PECVD). What is not considered as being part of the substrate is a substrate carrier (e.g. a leadframe of a package), an adhesive layer (a resin, a glue, solder material) used for mounting the substrate to a further part like a package or the substrate carrier.

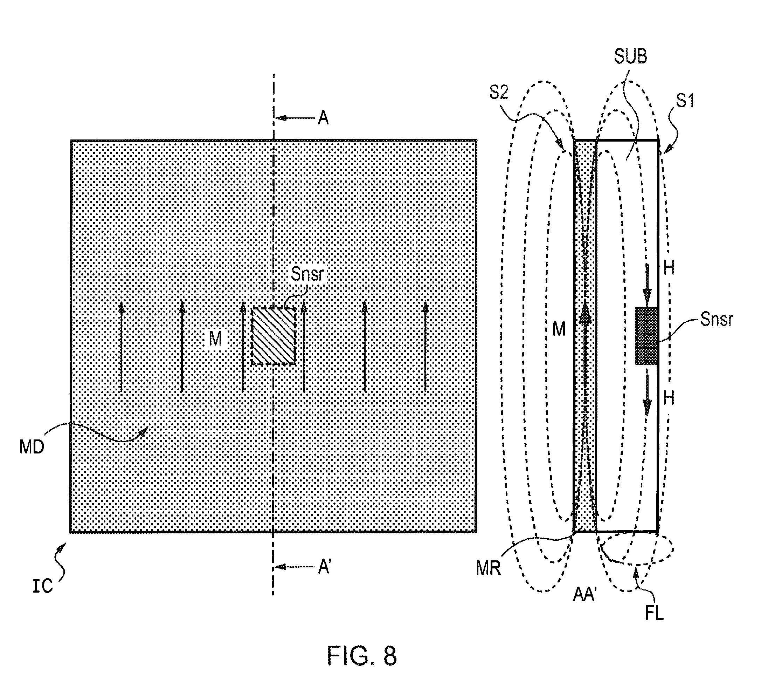

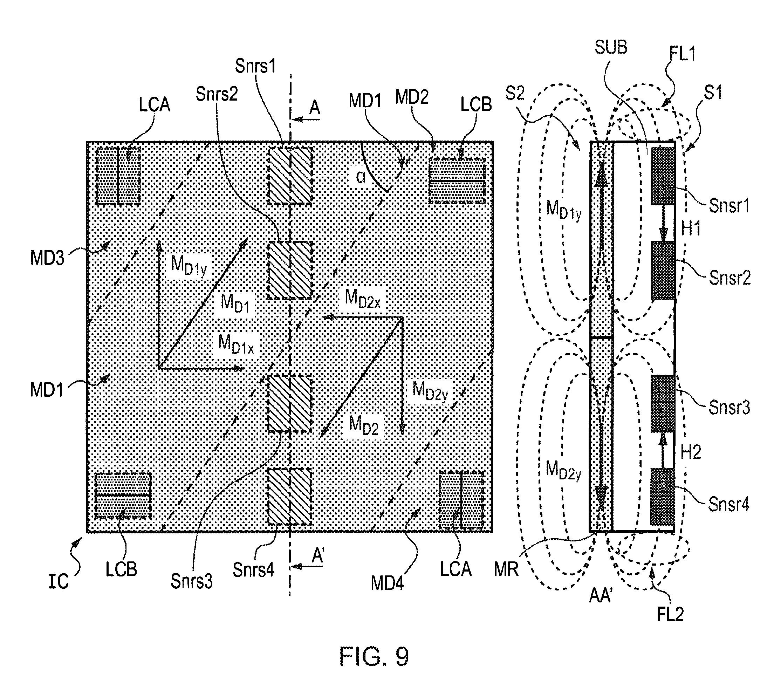

Fig. 8 and 9 show possible applications of the magnetic field sensor in accordance with the invention. Fig. 8 illustrates a schematic top-view and cross-sectional view of an integrated circuit in accordance with a sixth embodiment of the invention, featuring a first level of security against external attack from its second side S2 (back-side). The cross-sectional view on the right-hand side of the figure is taken at line AA' in the top-view on the left-hand side of the figure. The integrated circuit IC comprises a substrate SUB having a first side S1 (front-side) and a second side S2 (back-side). On the first side S1 an electronic circuit (not shown) is provided. The electronic circuit comprises a magnetic field sensor Snsr. On the second side S2 of the substrate SUB a magnetizable region MR has been provided by means of a wafer-level type deposition processing step. The magnetic field sensor in Fig. 8 (but also those in Fig. 9) is a transistor. This features both integration as a separate entity/block in the electronic circuit or it may be combined with another circuit like an analog-to-digital converter for example.

A magnetizable material like neodymium-iron-boron (NdFeB) or cobalt-platinum (CoPt) can be deposited on the second side S2 of the substrate SUB by means of a sputtering step. This can be done from a homogeneous target of these materials in a DC or RF type sputtering system in Argon (Ar) at a pressure of typically 1-20 mTorr. The magnetization takes place outside the sputtering system in either a homogeneous magnetic field (to obtain one, single, homogeneously magnetized domain) or by defining smaller, sub-chip scale regions by moving a smaller magnetization device (yoke) over the as-deposited film. By making this movement virtually random, a random distribution of magnetization domains can be obtained.

The magnetizable region MR is arranged such that it has sufficient coercivity and remanent magnetization to keep some magnetic "information" in it. Any magnetic information may then create a stray field which may be detected by the magnetic field sensor Snsr at the front side S1 of the integrated circuit IC. In Fig. 8 the magnetizable region MR is provided with one magnetization domain MD having a magnetic moment M. Expressed differently, a magnetization domain is defined as a domain having a magnetization in one predominant direction. In this example the magnetic moment M is in directed in a direction parallel to the first side S1 of the substrate SUB. The magnetization domain MD may cover the full backside S2 of the substrate SUB. The magnetic moment M of the magnetization domain MD is chosen such that a magnetic field H at location of the magnetic field sensor Snsr is detectable. In the cross-sectional view in Fig. 8 a couple of magnetic field lines FL are shown for illustrative purposes only. In reality the field lines FL may follow different paths than illustrated here. What is essential though is that the local magnetic field H at the location of the magnetic field sensor Snsr exceeds a certain minimum value such that it is detectable. This minimum value is also dependent on any background magnetic field which may be present. Obviously, measures could be taken to shield the integrated circuit IC from external magnetic fields. This may be done in the package of the integrated circuit IC, but increases the costs of integrated circuit IC. A resulting lower background magnetic field means that the lower limit of what is detectable may shift to lower magnetic field strengths. However, in that case the sensitivity of the magnetic field sensor Snsr may become the limiting factor.

In Fig. 8 the magnetic field sensor Snsr is placed in the middle of the integrated circuit IC which is for illustrative purposes only. Alternatively, the magnetic field sensor Snsr may be placed in any other location where there is a detectable magnetic field H. Further, the magnetic field sensor Snsr is provided adjacent to a surface at the first side S1. However, it may also be provided at a distance from the surface at the second side S2 of the substrate SUB. This is for instance the case if the integrated circuit IC comprises interconnection layers (not shown) and dielectrics (including a passivation layer) on top of components like transistors, capacitance, resistances, and inductances which form part of the electronic circuit. In this description, the wording "at the first side" is by no way intended to be restricted to "at the surface".

In Fig. 8 the magnetizable region MR is arranged for generating a magnetic field having mainly a lateral magnetic field component H at the location of the electronic circuit that runs parallel to the first side S1 of the substrate SUB. In accordance with this, the magnetic field sensor Snsr should be sensitive to the lateral magnetic field component. In alternative embodiments the magnetizable region MR is arranged for generating a magnetic field having a vertical magnetic field component at the location of the electronic circuit that runs perpendicular to the first side S1 of the substrate SUB. Analogously, the magnetic field sensor Snsr should be sensitive to the vertical magnetic field component. In further embodiments both concepts are mixed.

An attempt to remove the integrated circuit IC of Fig. 8 from its environment (e.g. a bank card or a package) may result in the magnetizable region MR getting damaged (partially removed) or even completely removed. This damaging or removal results in a change in the generated magnetic field and may be detected by the magnetic field sensor Snsr. After detection any appropriate action may be initiated (reset, erase of contents, self-destruction by blowing up fuse links, etc) which provides a first level of security against external attack. The magnetic field sensor Snsr may comprise analog to digital conversion means (AD converter) for producing digital output bits.

Fig. 9 illustrates a schematic top-view and cross-sectional view of an integrated circuit, accordance with a seventh embodiment of the invention, featuring a higher level of security against external attack from its second side S2 (back-side). The cross-sectional view on the right-hand side of the figure is taken at line AA' in the top-view on the left-hand side of the figure. In this embodiment of the integrated circuit IC the magnetic region MR is provided with four magnetization domains MD1, MD2, MD3, MD4, wherein each magnetization domain has a different magnetic moment M. A first one MD1 of the magnetization domains has a first magnetic moment $M_{D1}$ in a first direction, and a second one MD2 of the magnetization domains has a second magnetic moment $M_{D2}$ in a second direction opposite to the first direction. Between the first magnetization domain MD1 and the second magnetization domain MD2 there is an interface MDI having a varying direction of magnetization. This interface is also called a domain wall. In this example the interface MDI follows a straight line that makes an angle $\alpha$ with an edge of the substrate SUB. In other embodiments the interface may follow other curves and/or the interface may make a different angle with the edge of the substrate SUB.

At the first side S1 of the substrate an array of four magnetic field sensors Snsr1, Snsr2, Snsr3, Snsr4 have been provided. Just as in the embodiment of Fig. 8 the magnetic field sensors may comprise analog to digital conversion means (AD converter) for producing digital output bits. In the cross-sectional view in Fig. 9 a couple of magnetic field lines FL1 generated by the first magnetization domain MD1 and a couple of magnetic field lines FL2 generated by the second magnetization domain MD2 are shown. These magnetic field lines FL1, FL2 are shown for illustrative purposes only. In reality the field lines FL1, FL2 may follow different paths as illustrated here. What is essential though is that the local magnetic fields H1, H2 at the locations of the magnetic field sensors Snsr1, Snsr2, Snsr3, Snsr4 exceed a certain minimum value such that it is detectable. The first and second magnetic field sensor Snr1, Snsr2 have been placed in a magnetic field generated by the first magnetization domain MD1. The third and fourth magnetic field sensor Snsr3, Snsr4 have been placed in a magnetic field generated by the second magnetization domain MD2. The orientation of the magnetic field sensors Snsr1, Snsr2, Snsr3, Snsr4 is such that they are sensitive for magnetic field components extending in a direction of cross-sectional line AA' in Fig. 9 and parallel to the first side S1 of the substrate SUB. The local magnetic fields H1, H2 sensed by the magnetic field sensors Snsr1, Snsr2, Snsr3, Snsr4 are determined by, amongst other parameters (like the location of the sensors in the inhomogeneous magnetic field), the components of the magnetic moments $M_{D1y}$, $M_{D2y}$ in the direction of cross-sectional line AA' in Fig. 9 and parallel to the first side S1 of the substrate SUB.

Similarly as to the embodiment illustrated in Fig. 8, an attempt to remove the integrated circuit IC of Fig. 9 from its environment (e.g. a bank card or a package) may result in the magnetizable region MR getting damaged (partially removed) or even completely removed. This damaging or removal results in a change in the generated magnetic field and may be detected by one of the magnetic field sensors Snsr1, Snsr2, Snsr3, Snsr4. After detection any appropriate action may be initiated (reset, erase of contents, self-destruction by blowing up fuse links, etc) which provides a first level of security against external attack. Magnetic field sensors generally have a local detection range. Damaging the magnetizable region outside this range may then not be detected. The provision of more magnetic field sensors on the substrate in Fig. 9 enlarges the overall detection range and thus the security level of the integrated circuit IC. In Fig. 9, for illustration purposes, additional sensors have been added in corner locations LCA. Also, for illustrating the design freedom of a designer, in further corner locations LCB of the integrated circuit further additional sensors have been provided, which are sensitive to further magnetic field components $M_{D1x}$, $M_{D2x}$ perpendicular to the magnetic field components $M_{D1y}$, $M_{D2y}$.

When the magnetic field sensors Snsr1, Snsr2, Snsr3, Snsr4 are positioned in different magnetic fields H1, H2 this may result in a different read-out for each of the magnetic field sensors Snsr1, Snsr2, Snsr3, Snsr4. This feature may be exploited for creating a device specific identification code (chip-ID), which may be achieved by properly configuring the magnetizable region MR (number of magnetization domains, magnetic moment of the domains, size of the magnetization domains, etc) and/or by configuring the magnetic field sensor array Snsr1, Snsr2, Snsr3, Snsr4 (the number of magnetic field sensors, the position of the magnetic field sensors, the type/sensitivity of the magnetic field sensors, the orientation of the magnetic field sensors, etc). Using these various parameters, any sequence of desired output values of the magnetic field sensors may be obtained.

The easiest way to obtain a unique chip-ID is to configure the magnetizable region MR with a predetermined magnetization pattern and to incorporate a sufficiently dense array of sensing elements distributed over the first side of the integrated circuit IC. The detection distance is in the order of 100-750 microns (typical thickness of a substrate). A consequence of this is that, in order to achieve the best detection possibilities, the magnetization pattern may not have a too fine pitch (magnetization domains should not be too small).

A very attractive embodiment of the integrated circuit is obtained if the magnetization pattern of the magnetizable region MR is of a random nature in such a way that it cannot be exactly reproduced. The manufacturing of magnetic materials is well known to the person skilled in the art. Also, it is well-known to the person skilled in the art how to manufacture materials such that a random magnetization pattern occurs (see for instance: Robert C. O'Handley (MIT), "Modern Magnetic Materials. Principles and Applications. ", John Wiley & Sons, Inc, New York).

One may use a magnetization yoke of a particular shape that is alterable in order to obtain a "random" magnetization pattern. The reference mentioned above illustrates that materials exist that possess a random distribution of their magnetization pattern by nature. This is observable e.g. in thin-film single-crystal magnetic garnets (Yttrium Iron Garnet (YIG)) with a perpendicular anisotropy. The domains are visible as a "spaghetti" type of ordering, called stripe domains. For more information on this see also:

> "http://psroc.phys.ntu.edu.tw/cjp/download.php?
> d=1&pid=1685"
> and
> "http://depts.washington.edu/kkgroup/publica-
> tions/PDF/2004_Chun_Fe_domain_coup.pdF'.

With "random magnetization pattern" it is meant that the magnetization pattern consists of domains having a random position, size, or orientation, when considering a plurality of integrated circuits manufactured in one or more batches for example. Once, the magnetizable region has such random magnetization pattern, it has become virtually impossible to reproduce such magnetizable region. This will then create a Physical Uncloneable Function, from now on being referred to as a PUF.

Recently, so-called Physical Uncloneable Functions (PUFs) were introduced by Pappu "Physical One-Way Functions" MIT, March 2001 as a cost-effective way of generating secure keys for cryptographic purposes. PUF are described for use as a hash function and for authentication purposes. Because through PUFs the data is stored essentially in a material rather than in a circuit, the technology can also be used as part of a device that needs authentication, such as a security sensor. Many further developments focus on developing different types of PUFs. The application of PUFs focuses on using PUFs as unique identifiers for smart-cards and credit cards or as a 'cheap' source for key generation (common randomness) between two parties, see P.Tuyls e.a. "Information-Theoretic Security Analysis of Physical Uncloneable Functions", based on the very useful properties of PUF of the uniqueness of the responses and uncloneability of the PUF.

In case a PUF is used in a system for secure storage of digital data, such a system may comprise:

- a data storage (e.g. an embedded memory or a stand-alone memory);
- a physical uncloneable function, hereinafter referred to as PUF, including an input for receiving a challenge and an output for producing a response to the challenge;
- means for determining an identifier associated with the data storage;
- means for supplying a representation of the identifier to the PUF as a challenge and retrieving a corresponding response from the PUF;
- a cryptographic unit for performing a cryptographic operation for securing or verifying a digital content item stored in the data storage, where the cryptographic operation is performed under control of a cryptographic key derived from the received response.

In this system, the PUF is used to generate the cryptographic key. The input to the PUF is associated with the data storage. As such, the PUF binds the cryptographic key to the data storage. Since the PUF is uncloneable, cloning of content stored in the data storage becomes useless. The cryptographic operations on the cloned content item will not produce the desired result without the original PUF. The cryptographic operation may be any cryptographic operation, preferably authentication or encryption/decryption.

The integrated circuit IC according to the invention may also be made tamper-resistant by making the magnetizable region MR opaque for at least infrared and visible light. When the magnetizable region MR is opaque for at least infrared and visible light and when the magnetizable region MR and the electronic circuit are positioned with respect to each other in the above described way, a higher security level is obtained. Optical inspection methods from the back-side S2 have been rendered virtually impossible without removing the magnetizable region MR. However, such removal would inevitable be detected by the magnetic fields sensors Snsr1, Snsr2, Snsr3, Snsr4, which may be used to clear the secure contents in the electronic circuit. Alternatively, it may be used to deactivate or reset the electronic circuit.

Almost every magnetic material is opaque, such as ferrites, metallic magnetic alloys, nanocrystalline materials. Exceptions are some types of garnets, such as Yttrium Iron Garnet (YIG), which are transparent.

Fig. 10 shows a schematic cross-sectional view of a card comprising an integrated circuit in accordance with the invention. The card 100 comprises a recess in which an integrated circuit is provided. The integrated circuit comprises a substrate 5. On a front-side of the substrate 5 a plurality of magnetic field sensors 45 is provided, and on a back-side of the substrate 5 a magnetizable layer 50a is provided. The magnetizable layer 50a has been provided with a magnetic moment such that the magnetic field generated by it is detectable at the location of the plurality of magnetic field sensors 45. The substrate 5 is mounted on an electrically-conductive substrate carrier 50b (e.g. with an adhesive layer). The substrate carrier 50b is patterned in separate conductors. The integrated circuit in Fig. 10 is further provided with bond-pads 70 on its front-side which are connected to the substrate carrier 50b via bonding wires 80. The substrate carrier is used to connect the substrate 5 to the outside world via the separate conductors of the electrically-conductive substrate carrier 50b.Also, a passivation layer 60 may be provided over the semiconductor device having holes at locations of the bondpads 70 which are connected to the substrate carrier 50b. By way of an example application the assembly has been mounted into a plastic card 100 which is the case in smart-card applications for example. In an attempt to remove the integrated circuit from its environment the substrate carrier 50b is removed. While removing the substrate carrier, the magnetizable region 50a may be partially removed (damaged) or completely removed. This removal will influence the magnetic field sensed by the magnetic field sensor. As soon as a magnetic field change is detected (thus a change in authenticity) the integrated circuit takes measures to prevent a hacker to retrieve information stored thereon, e.g. by erasing its contents or by resetting itself. A more secure card is thus obtained.

In an alternative embodiment the substrate carrier 50b is also provided with a magnetic moment. The magnetic field sensed by the magnetic field sensors 45 is then a sum of the magnetic field generated by the magnetizable layer 50a and the substrate carrier 50b. In this embodiment the removal of the integrated circuit from the card 100 is already detected even if the magnetizable region 50a stays fully intact (which may be the case if the hacker operates with extreme care).

The magnetic field sensor in accordance with invention is advantageously integrated in a card 100 as illustrated in Fig. 10, because of its compatibility with triple-well CMOS technology which is very likely a mainstream process technology starting from the 65nm technology node.

The invention thus provides, in a first aspect, a magnetic field sensor comprising a substrate having a first side. The substrate comprises at the first side a silicon comprising semiconductor layer which comprises a buried N-well. A bipolar transistor having an emitter formed by an emitter region, a base formed by a base region, and a collector formed by a first collector region and a second collector region, is provided in the silicon comprising semiconductor layer. The emitter region is located at the first side above the buried N-well. According to the invention the bipolar transistor is arranged such that, in operation, a part of an emitter current that traverses the base region is distributed over the first and second collector regions obtaining a first and a second collector current, wherein a difference between the first and second collector currents is determined by a magnetic field component perpendicular to a current plane. A bipolar magneto-transistor structure is obtained which is compatible with triple-well technology and that is sensitive to magnetic fields in a direction perpendicular to the current plane. Compatibility of the magnetic field sensor with triple-well technology also resides in the presence of a buried N-well underneath the emitter region. The split-collector configuration enables a high linearity and a high sensitivity.

The invention provides, in a second aspect, an integrated circuit comprising a substrate having a first side and a second opposing side. At the first side of the substrate an electronic circuit is provided which electronic circuit comprises at least one magnetic field sensor in accordance with the invention. On the second side of the substrate a magnetizable region is provided by using a wafer-level type deposition processing step, a magnetic moment of the magnetizable region being configurable for generating a magnetic field detectable at the location of the at least one magnetic field sensor. The integrated circuit constitutes a very simple construction. All what is needed is a magnetizable region on the second side and at least one magnetic field sensor on the first side of the substrate. Above that, these additional features can be provided on the substrate using lithographic techniques which enables a strongly miniaturized solution which is, because of its reduced dimensions well suitable for being used in bank cards. An attempt to remove the integrated circuit according to the invention from its environment (e.g. a bank card) may result in the magnetizable region getting damaged (partially removed) or even completely removed. In case the magnetizable region has been magnetized (such that it has a magnetic moment that results in a magnetic field detectable at the location of the at least one magnetic field sensor) this damaging or removal may be detected by the at least one magnetic field sensor according to the invention which provides a first level of security against external attack. The magnetic field sensor in accordance with invention is advantageously integrated with the integrated circuit, because of its compatibility with triple-well CMOS technology which is very likely a mainstream process technology starting from the 65nm technology node.

The invention provides, in a third aspect, a card provided with such integrated circuit. In an attempt to remove the integrated circuit from the card the magnetizable region may be partially removed (damaged) or completely removed. This removal will influence the magnetic field sensed by the magnetic field sensor. As soon a magnetic field change which may be an authenticity violation is detected the integrated circuit takes measures to prevent a hacker to retrieve information stored thereon, e.g. by erasing its contents or by resetting itself. The card in accordance with the invention is more secure.

The invention may be applied in various application areas. As discussed earlier in the description, the magnetic-field sensor may be used for the measurement of stray fields from a hard-magnetic layer or body which is attached to the backside of a chip in order to detect if that layer or body is still present as a protection against intrusion or observation through that backside. Other applications may include major ones like: mechanical sensors for motion or lateral / rotational displacement (brushless motors, keyboard switches, etc.), non-contact current measurement, biomedical applications, electronic compass.

Various variations of the magnetic field sensor and integrated circuit in accordance with the invention are possible and do not depart from the scope of the invention as claimed.

### Claims

1. Magnetic field sensor comprising a silicon comprising semiconductor substrate (P-SUB) having a first side (S1), the substrate (P-SUB) being of a first conductivity type, the substrate (P-SUB) comprising a buried N-well (DNW), the substrate (P-SUB) comprising a bipolar transistor having an emitter (EM), a base, and a collector, the substrate (P-SUB) comprising: a first collector region (CLR1) and a second collector region (CLR2) of a second conductivity type, the first and second collector regions (CLR1, CLR2) forming part of the collector (CL1, CL2) of the bipolar transistor, wherein the emitter (PE+, NE+) is located at the first side (S1) above the buried N-well (DNW), wherein the first and second collector regions (CLR1, CLR2), the base (PB+, NB+), and the emitter (PE+, NE+) are positioned with respect to each other such that, in operation, a part of an emitter current (IEM) that traverses the base (PB+, NB+) is distributed over the first and second collector regions (CLR1, CLR2) obtaining a first and a second collector current (ICL1, ICL2), wherein a difference between the first and second collector currents (ICL1, ICL2) is determined by a magnetic field component (Bx, Bz) perpendicular to a current plane, the magnetic field sensor being **characterized in that** the current plane is defined through the emitter(PE+, NE+), the base (PB+, NB+) and the first and second collector regions (CLR1, CLR2) and extends in directions defined by the emitter current (IEM) and the first and second collector currents (ICL1, ICL2).

2. Magnetic field sensor as claimed in claim 1, wherein the current plane extends in a direction perpendicular to the first side (S1) of the substrate, wherein the collector regions (CLR1, CLR2) are formed in the buried N-well (DNW), wherein a base region (PB+) forming the base is a p-type semiconductor and an emitter region (NE+) constituting the emitter is n-type semiconductor.

3. Magnetic field sensor as claimed in claim 2, wherein the buried N-wel (DNW) comprises two parts (DNW1, DNW2) separated in a direction parallel to the first side (S1) by a separating region (SR) of the substrate (P-SUB), the two parts (DNW1, DNW2) forming the first and second collector regions (CLR1, CLR2).

4. Magnetic field sensor as claimed in claim 3, wherein the separating region (SR) of the semiconductor substrate (P-SUB) is centrally aligned with the emitter region (NE+) when viewed from a direction perpendicular to the substrate (P-SUB).

5. Magnetic field sensor as claimed in claim 3, wherein the separating region (SR) of the semiconductor substrate (P-SUB) and the emitter region (NE+) are centrally offset with a predefined distance when viewed from a direction perpendicular to the substrate (P-SUB).

6. Magnetic field sensor as claimed in any one of claims 2 to 5, wherein the sensor further comprises a third collector region and a fourth collector region of the second conductivity type, the third and fourth collector region forming part of the collector (CL1, CL2, CL3, CL4) of the bipolar transistor, wherein the third and fourth collector region, the base region (PB+), and the emitter region (NE+) are positioned with respect to each other such that, in operation, a part of an emitter current (IEM) that traverses the base region (PB+) is also distributed over the third and fourth collector regions obtaining a third and a fourth collector current, wherein a difference between the third and fourth collector currents is determined by a further magnetic field component (By) perpendicular to a further current plane that extends in a direction perpendicular to the first side (S1) of the substrate (P-SUB), wherein the further current plane is defined through the emitter region (NE+), the base region (PB+) and third and fourth collector regions and extends in directions defined by flow directions of the emitter current (IEM) and the third and fourth collector currents.

7. Magnetic field sensor as claimed in claim 1, wherein the collector regions (NC 1+, NC2+, PC1+, PC2+), the base region (NW, PW), and the emitter region (PE+, NE+) are located at the first side (S1) above the buried N-well (DNW) and positioned with respect to each other in a direction parallel to the first side (S1).

8. Magnetic field sensor as claimed in claim 7-, wherein the collector regions (NC 1+, NC2+, PC1+, PC2+) and the emitter region (PE+, NE+) of the second conductivity type are formed in the base region (NW, PW) of the first conductivity type.

9. Magnetic field sensor as claimed in claim 8, wherein the base region (PB+, NB+) comprises two base contact regions (NB 1+, NB2+, PB1+, PB2+) of the first conductivity type but having a higher dopant concentration, a first one of the two base contact regions (NB 1+, PB1+) being positioned on a side of the emitter region (PE+, NE+) facing the collector regions (NC 1+, NC2+, PC1+, PC2+) or opposite thereto, and a second one of the two base contact regions (PB 1+, PB2+) being positioned on a side of the collector regions (NC 1+, NC2+, PC1+, PC2+) opposite to a side facing the emitter region (PE+, NE+), or on an opposing side of the emitter region (PE+, NE+).

10. Integrated circuit comprising at least one magnetic field sensor as claimed in any one of the preceding claims.

**Patentansprüche**

1. Magnetfeldsensor, aufweisend ein Silizium aufweisendes Halbleitersubstrat (P-SUB), welches eine erste Seite (S1) hat, wobei das Substrat (P-SUB) von einem ersten Leitfähigkeitstyp ist, wobei das Substrat (P-SUB) einen verdeckten N-Well (DNW) aufweist, wobei das Substrat (P-SUB) einen bipolaren Transistor aufweist, welcher einen Emitter (EM), eine Basis, und einen Kollektor hat, wobei das Substrat (P-SUB) aufweist: einen ersten Kollektorbereich (CLR1) und einen zweiten Kollektorbereich (CLR2) eines zweiten Leitfähigkeitstyps, wobei der erste und der zweite Kollektorbereich (CLR1, CLR2) einen Teil des Kollektors (CL1, CL2) des bipolaren Transistors bilden, wobei der Emitter (PE+, NE+) bei der ersten Seite (S1) über dem verdeckten N-Well (DNW) lokalisiert ist, wobei der erste und der zweite Kollektorbereich (CLR1, CLR2), die Basis (PB+, NB+) und der Emitter (PE+, NE+) bezüglich zueinander derart positioniert sind, dass im Betrieb ein Teil eines Emitterstroms (IEM), welcher die Basis (PB+, NB+) traversiert, über den ersten und den zweiten Kollektorbereich (CLR1, CLR2) verteilt ist, erhaltend einen ersten und einen zweiten Kollektorstrom (ICL1, ICL2), wobei eine Differenz zwischen dem ersten und dem zweiten Kollektorstrom (ICL1, ICL2) mittels einer Magnetfeldkomponente (Bx, Bz) bestimmt ist, welche senkrecht zu einer Stromebene ist, wobei der Magnetfeldsensor **dadurch gekennzeichnet ist,**
**dass** die Stromebene durch den Emitter (PE+, NE+), die Basis (PB+, NB+) und den ersten und den zweiten Kollektorbereich (CLR1, CLR2) definiert ist und sich in Richtungen erstreckt, welche mittels des Emitterstroms (IEM) und mittels des ersten und des zweiten Kollektorstroms (ICL1, ICL2) definiert sind.

2. Magnetfeldsensor gemäß Anspruch 1, wobei sich die Stromebene in einer Richtung senkrecht zu der ersten Seite (S1) des Substrats erstreckt, wobei die Kollektorbereiche (CLR1, CLR2) in dem verdeckten N-Well (DNW) gebildet sind, wobei ein Basisbereich (PB+), welcher die Basis bildet, ein P-Typ-Halbleiter ist und wobei ein Emitterbereich (NE+), welcher den Emitter konstituiert, ein N-Typ-Halbleiter ist.

3. Magnetfeldsensor gemäß Anspruch 2, wobei der verdeckte N-Well (DNW) zwei Teile (DNW1, DNW2) aufweist, welche in einer Richtung parallel zu der ersten Seite (S1) mittels eines Separationsbereiches (SR) des Substrats (P-SUB) getrennt sind, wobei die zwei Teile (DNW1, DNW2) den ersten und den zweiten Kollektorbereich (CLR1, CLR2) bilden.

4. Magnetfeldsensor gemäß Anspruch 3, wobei der Separationsbereich (SR) des Halbleitersubstrats (P-SUB) zentral mit dem Emitterbereich (NE+) ausgerichtet ist, wenn von einer Richtung senkrecht zu dem Substrat (P-SUB) gesehen.

5. Magnetfeldsensor gemäß Anspruch 3, wobei der Separationsbereich (SR) des Halbleitersubstrats (P-SUB) und der Emitterbereich (NE+) zentral um eine vordefinierte Distanz versetzt sind, wenn von einer Richtung senkrecht zu dem Substrat (P-SUB) gesehen.

6. Magnetfeldsensor gemäß einem der Ansprüche 2 bis 5, wobei der Sensor ferner einen dritten Kollektorbereich und einen vierten Kollektorbereich des zweiten Leitfähigkeitstyps aufweist, wobei der dritte und der vierte Kollektorbereich einen Teil des Kollektors (CL1, CL2, CL3, CL4) des bipolaren Transistors bilden, wobei der dritte und der vierte Kollektorbereich, der Basisbereich (PB+), und der Emitterbereich (NE+) derart bezüglich zueinander positioniert sind, dass im Betrieb ein Teil eines Emitterstroms (IEM), welcher den Basisbereich (PB+) traversiert, auch über den dritten und den vierten Kollektorbereich verteilt ist, erhaltend einen dritten und einen vierten Kollektorstrom, wobei eine Differenz zwischen dem dritten und dem vierten Kollektorstrom mittels einer weiteren Magnetfeldkomponente (By) bestimmt ist, welche senkrecht zu einer weiteren Stromebene ist, welche sich in einer Richtung senkrecht zu der ersten Seite (S1) des Substrats (P-SUB) erstreckt, wobei die weitere Stromebene durch den Emitterbereich (NE+), den Basisbereich (PB+) und den dritten und den vierten Kollektorbereich definiert ist und sich in Richtungen erstreckt, welche mittels Flussrichtungen des Emitterstroms (IEM) und des dritten und des vierten Kollektorstroms definiert sind.

7. Magnetfeldsensor gemäß Anspruch 1, wobei die Kollektorbereiche (NC1+, NC2+, PC1+, PC2+), der Basisbereich (MW, PW), und der Emitterbereich (PE+, NE+) bei der ersten Seite (S1) über dem verdeckten N-Well (DMW) lokalisiert sind und bezüglich zueinander in einer Richtung parallel zu der ersten Seite (S1) positioniert sind.

8. Magnetfeldsensor gemäß Anspruch 7, wobei die Kollektorbereiche (NC1+, NC2+, PC1+, PC2+) und der Emitterbereich (PE+, ME+) des zweiten Leitfähigkeitstyps in dem Basisbereich (NW, PW) des ersten Leitfähigkeitstyps gebildet sind.

9. Magnetfeldsensor gemäß Anspruch 8, wobei der Basisbereich (PB+, NB+) zwei Kontaktbereiche (NB1+, NB2+, PB1+, PB2+) des ersten Leitfähigkeitstyps aber mit einer höheren Dotierungskonzentration aufweist, wobei ein erster der zwei Basiskontaktbereiche (NB1+, PB1+) auf einer Seite des Emitterbereichs (PE+, NE+) positioniert ist, welche den Kollektorbereichen (NC1+, NC2+, PC1+, PC2+) zugewandt ist oder diesen gegenübersteht, und wobei ein zweiter der zwei Basiskontaktbereiche (PB1+, PB2+) auf einer Seite der Kollektorbereiche (NC1+, NC2+, PC1+, PC2+) gegenüber einer Seite positioniert ist, welche dem Emitterbereich (PE+, NE+) zugewandt ist, oder auf einer gegenüberliegenden Seite des Emitterbereichs (PE+, NE+).

10. Integrierte Schaltung, welche zumindest einen Magnetfeldsensor gemäß einem der vorangehenden Ansprüche aufweist.

**Revendications**

1. Capteur de champ magnétique comprenant un silicium comprenant un substrat semi-conducteur (P-SUB) ayant une première face (S1), le substrat (P-SUB) étant d'un premier type de conductivité, le substrat (P-SUB) comprenant un puits enterré N (DNW), le substrat (P-SUB) comprenant un transistor bipolaire ayant un émetteur (EM), une base et un collecteur, le substrat (P-SUB) comprenant : une première région de collecteur (CLR1) et une deuxième région de collecteur (CLR2) d'un deuxième type de conductivité, la première et la deuxième région de collecteur (CLR1, CLR2) formant une partie du collecteur (CL1, CL2) du transistor bipolaire, dans lequel l'émetteur (PE+, NE+) est situé sur la première face (S1) au-dessus du puits enterré N (DNW), dans lequel la première et la deuxième région de collecteur (CLR1, CLR2), la base (PB+, NB+) et l'émetteur (PE+, NE+) sont positionnés les uns par rapport aux autres de telle sorte que, en fonctionnement, une partie d'un courant d'émetteur (IEM) qui traverse la base (PB+, NB+) se distribue entre la première et la deuxième région de collecteur (CLR1, CLR2), ce qui permet d'obtenir un premier et un deuxième courant de collecteur (ICL1, ICL2), dans lequel une différence entre le premier et le deuxième courant de collecteur (ICL1, ICL2) est déterminée par une composante du champ magnétique (Bx, Bz) perpendiculaire à un plan du courant,
le capteur de champ magnétique étant **caractérisé par le fait que** le plan du courant est défini à travers l'émetteur (PE+, NE+), la base (PB+, NB+) et la première et deuxième régions de collecteur (CLR1, CLR2) et s'étend dans des directions définies par le courant d'émetteur (IEM) et les premier et deuxième courants de collecteur (ICL1, ICL2).

2.  Capteur de champ magnétique selon la revendication 1, dans lequel le plan du courant s'étend dans une direction perpendiculaire à la première face (S1) du substrat, dans lequel les régions de collecteur (CLR1, CLR2) sont formées dans le puits enterré N (DNW), dans lequel une région de base (PB+) formant la base est un semi-conducteur de type p et une région d'émetteur (NE+) formant l'émetteur est un semi-conducteur de type n.

3.  Capteur de champ magnétique selon la revendication 2, dans lequel le puits enterré N (DNW) comporte deux parties (DNW1, DNW2) séparées dans une direction parallèle à la première face (S1) par une région de séparation (SR) du substrat (P-SUB), les deux parties (DNW1, DNW2) formant la première et la deuxième région de collecteur (CLR1, CLR2).

4.  Capteur de champ magnétique selon la revendication 3, dans lequel la région de séparation (SR) du substrat semi-conducteur (P-SUB) est alignée de manière centrale avec la région d'émetteur (NE+), quand elle est vue d'une direction perpendiculaire au substrat (P-SUB).

5.  Capteur de champ magnétique selon la revendication 3, dans lequel la région de séparation (SR) du substrat semi-conducteur (P-SUB) et la région d'émetteur (NE+) sont décalées par rapport au centre d'une distance prédéfinie, lorsqu'elles sont vues d'une direction perpendiculaire au substrat (P-SUB).

6.  Capteur de champ magnétique selon l'une quelconque des revendications 2 à 5, dans lequel le capteur comporte en outre une troisième région de collecteur et une quatrième région de collecteur du deuxième type de conductivité, la troisième et la quatrième région de collecteur formant une partie du collecteur (CL1, CL2, CL3, CL4) du transistor bipolaire, dans lequel la troisième et la quatrième région de collecteur, la région de base (PB+) et la région d'émetteur (NE+) sont positionnées les unes par rapport aux autres de telle sorte que, en fonctionnement, une partie du courant d'émetteur (IEM) qui traverse la région de base (PB+) se distribue également entre la troisième et la quatrième région de collecteur, ce qui permet d'obtenir un troisième et un quatrième courant de collecteur, dans lequel une différence entre le troisième et le quatrième courant de collecteur est déterminée par une autre composante du champ magnétique (By) perpendiculaire à un autre plan du courant qui s'étend dans une direction perpendiculaire à la première face (S1) du substrat (P-SUB), dans lequel l'autre plan du courant est défini à travers la région d'émetteur (NE+), la région de base (PB+) et la troisième et quatrième régions de collecteur, et s'étend dans des directions définies par le courant d'émetteur (IEM) et les troisième et quatrième courants de collecteur.

7.  Capteur de champ magnétique selon la revendication 1, dans lequel les régions de collecteur (NC1+, NC2+, PC1+, PC2+), la région de base (NW, PW) et la région d'émetteur (PE+, NE+) sont situées sur la première face (S1) au-dessus du puits enterré N (DNW) et sont positionnées les unes par rapport aux autres dans une direction parallèle à la première face (S1).

8.  Capteur de champ magnétique selon la revendication 7, dans lequel les régions de collecteur (NC1+, NC2+, PC1+, PC2+) et la région d'émetteur (PE+, NE+) du deuxième type de conductivité sont formées dans la région de base (NW, PW) du premier type de conductivité.

9.  Capteur de champ magnétique selon la revendication 8, dans lequel la région de base (PB+, NB+) comporte deux régions de contact de base (NB1+, NB2+, PB1+, PB2+) du premier type de conductivité mais ayant une concentration de dopants plus élevée, une première des deux régions de contact de base (NB1+, PB1+) étant positionnée d'un côté de la région d'émetteur (PE+, NE+) faisant face aux régions de collecteur (NC1+, NC2+, PC1+, PC2+) ou à l'opposé de celles-ci, une deuxième des deux régions de contact de base (PB1+, PB2+) étant positionnée d'un côté des régions de collecteur (NC1+, NC2+, PC1+, PC2+) opposées à un côté faisant face à la région d'émetteur (PE+, NE+), ou sur un côté opposé à la région d'émetteur (PE+, NE+).

10. Circuit intégré comprenant au moins un capteur de champ magnétique selon l'une quelconque des revendications précédentes.

FIG. 1

FIG. 2

FIG. 3

FIG. 4

FIG. 6

FIG. 7

FIG. 8

EP 2 203 756 B1

FIG. 9

FIG. 5

FIG. 10

**REFERENCES CITED IN THE DESCRIPTION**

**Patent documents cited in the description**

- US 4700211 A
- US 2004212029 A
- US 2005230770 A
- US 20050230770 A
- GB 2126009 A

**Non-patent literature cited in the description**

- **Schneider et al.** Integrated micromachined decoup/ed CMOS chip on chip. *Micro Electro Mechanical Systems, 1997, MEMS '97, Proc. IEEE,* 26 January 1997, 512-517
- **S. Middelhock ; S.A. Audet.** Silicon sensors. Academic Press, 1989
- **S. Middelhoek ; S.A. Audet.** Silicon sensors. Academic Press, 1989
- Modern Magnetic Materials. Principles and Applications. **Robert C. O'Handley.** MIT. John Wiley & Sons, Inc
- **Pappu.** Physical One-Way Functions. *MIT,* March 2001